# EUROPEAN PATENT SPECIFICATION

(11) **EP 3 760 408 B1**
(45) Date of publication and mention of the grant of the patent: **10.09.2025**
(21) Application number: 19775176.1
(22) Date of filing: 27.03.2019
(51) Int. Cl.: B29C 39/42, B29C 39/10, B29C 39/38, H01L 21/56

(54) **METHOD FOR MANUFACTURING MOLDED ARTICLE, AND METHOD FOR MANUFACTURING ELECTRONIC COMPONENT DEVICE**
VERFAHREN ZUR HERSTELLUNG EINES FORMARTIKELS UND VERFAHREN ZUR HERSTELLUNG EINES ELEKTRONISCHEN BAUELEMENTS
PROCÉDÉ DE FABRICATION D'ARTICLE MOULÉ ET PROCÉDÉ DE FABRICATION DE DISPOSITIF COMPOSANT ÉLECTRONIQUE

(30) Priority: 29.03.2018 JP 2018064690
(43) Date of publication of application: 06.01.2021
(73) Proprietor: Resonac Corporation, Tokyo 105-7325 (JP)
(72) Inventor: ARATA, Michitoshi, Tokyo 100-6606 (JP); MURASUGI, Narutoshi, Tokyo 100-6606 (JP); TOGAWA, Mitsuo, Tokyo 100-6606 (JP)
(74) Representative: Hoffmann Eitle
(86) International application number: PCT/JP2019/013362
(87) International publication number: WO 2019/189464

(56) References cited:
- WO-A1-2008/053866
- WO-A1-2013/110128
- GB-A- 674 519
- GB-A- 859 006
- JP-A- 2005 064 456
- JP-A- 2010 162 710
- JP-A- S6 471 137
- JP-A- S61 502 045
- US-A- 4 963 307
- US-A1- 2010 041 184

## Description

### Technical Field

The present disclosure is related to a method of making a molded body and a method of making an electronic component device.

### Background Art

In electronic devices, increase in mounting density is progressing due to the recent trend of size reduction and multi-functionalization, and further, the amount of heat generation is increasing due to increase in output. In response to the above, heat resistance is demanded for resin compositions used for protecting modules having a chip, an insulating substrate, a copper-based plate, a solder, wires or the like from outside environment, since they are incorporated into electronic component devices.

Examples of the modules which generate a large amount of heat and which are required to be usable under high temperature for a long time include power modules used for motor vehicles, electric railroads or the like. The amount of heat production in the chips of power modules is significantly high, since high voltages are applied to them, and therefore, it is requested that operation under high temperature be guaranteed in power modules, including their components.

As a method of sealing a power module, a method in which sealing is conducted by pouring silicone gel into a case mold which is open to atmospheric environment, is known (for example, refer to Patent Literature 1). Since silicone gel is in a liquid state at room temperature (25°C), the method described in Patent Literature 1 does not require forming a sealed state with a surrounding mold, unlike compression molding or the like, and therefore, is advantageous in that filling of the case, which is open, can be conducted easily and uniformly by the gravity of the silicone gel itself.

Patent Literature 2 relates to a method of producing a resin tablet comprising: placing a resin material having voids in a vacuum vessel and evacuating the vessel to remove air trapped in the voids of said resin material; and heating the resin material to a temperature below the softening point of the resin material and applying pressure to said resin material to fuse at least a shell of said resin material and form a resin tablet substantially free of open pores.

Patent Literature 3 relates to a molding apparatus including an upper half having a substrate mounting plate; and a lower half coupled with the upper half to form a cavity there between, wherein the substrate mounting plate faces the cavity, wherein the lower half includes a projecting part which has a top surface which faces the cavity and which projects from the bottom surface of the lower half toward a substantial center point of the substrate mounting plate, wherein the substrate mounting plate is adjustably mounted on the upper half and movable toward the lower half, and wherein the upper half includes a clamp mounted thereon which surrounds the projecting part when the upper and lower halves are coupled with each other.

Patent Literature 4 relates to method for molding a resin as a scaffold by immersing a biodegradable resin in a mold having an irregular three-dimensional shape with an internal porosity of 30% or less, comprising the steps of: heating a biodegradable resin in a resin container, degassing the biodegradable resin in the molten state and the surrounding atmosphere of the mold, leaving the mold in the biodegradable resin for at least 10 minutes under reduced pressure degassed state, and returning the peripheral atmosphere of the mold to the reference pressure while maintaining the molten state of the biodegradable resin.

Patent Literature 5 relates to resins/filler composites that are formed via a resin infusion process.

Patent Literature 6 relates to a process in which polyethylene is molded in fused condition under sub-atmospheric pressure which is low enough to allow the volatile ingredients to escape from the melt. The material may be fused in the mold, or fused outside the mold and poured thereinto.

Patent Literature 7 relates to a process of casting or molding a material that normally tends to entrap air in the molded product or which tends to oxidize when heated in air to a temperature at which it will flow, which comprises placing a mold containing the material to be molded, in granular or pellet form, in a vacuum-tight vessel, exhausting air from the vessel, and applying heat to the material to cause it to melt or soften and flow in the mold.

Patent Literature 8 relates to a resin sealing device in which a granular resin is placed on a release film, and by using a preliminarily fused resin molded on the release film, a molded article is resin-sealed.

### Citation List

### Patent Literature

Patent Literature 1: Japanese Patent Application Laid-Open (JP-A) No. 2014-216558
Patent Literature 2: US 4 963 307 A
Patent Literature 3: US 2010/041184 A1
Patent Literature 4: WO 2008/053866 A1
Patent Literature 5: WO 2013/110128 A1
Patent Literature 6: GB 674 519 A
Patent Literature 7: GB 859 006 A
Patent Literature 8: JP 2010 162710 A

### SUMMARY OF INVENTION

### Technical Problem

However, in the method described in Patent Literature 1, reliability under high temperature is poor, since the coefficients of thermal expansion between the components of the power module and the silicone gel covering the entire components are far different. Further, there are problems such as occurrence of contact fault caused by siloxane due to the heat generated from the chip. Therefore, materials that replace silicone gel are being searched for. One conceivable example is to employ a liquid epoxy resin composition as a material for sealing using a case mold, considering that conventional devices can be used. However, there are concerns regarding liquid epoxy resin compositions in terms of heat resistance and retention under high temperature. From the viewpoints of heat resistance, retention under high temperature and the like, usage of resin compositions that are solid at room temperature (25°C) can be considered.

In the meantime, in sealing electronic devices, it is requested that high fillability be assured while minimizing empty spaces such as voids from the viewpoint of assuring reliability. However, in the case in which a solid resin composition is molded using a case mold (hereinafter, the method in which the molding is conducted by disposing a resin composition in a case mold is also referred to as "case molding"), air present in spaces between the solid resin composition tends to be caught into the composition thereby generating air bubbles during the melting of the resin composition. Further, in the case molding, since no pressure is applied during the molding, unlike transfer molding, compression molding or the like, the air bubbles mixed therein are less likely to be crushed. Accordingly, when case molding is performed using a solid resin composition, reduction in occurrence of voids is of particular interest.

In view of the above situation, the present disclosure is related to providing a method of making a molded body capable of controlling occurrence of voids in case molding using a solid resin composition, and a method of making an electronic component device using the method of making a molded body.

### Solution to Problem

A solution to the above problem includes the method of making a molded body and the method of making an electronic component device as defined in the appended claims. Advantageous Effects of Invention

According to the present disclosure, a method of making a molded body capable of controlling occurrence of voids in case molding using a solid resin composition, and a method of making an electronic component devise using the method of making a molded body, are provided.

### DESCRIPTION OF EMBODIMENTS

In the present disclosure, a numerical range described using "to" indicates a range including the numerical values before and after "to" as a minimum value and a maximum value, respectively.

In numerical ranges described herein in a stepwise manner, an upper limit value or a lower limit value described in one numerical range may be replaced with an upper limit value or a lower limit value of another numerical range described in a stepwise manner. In addition, in a numerical range described in the present disclosure, the upper limit value or the lower limit value of the numerical range may be replaced with a value described in the Examples section.

In the present disclosure, a component may include a plurality of different kinds of substances corresponding thereto. In a case in which there are a plurality of different kinds of substances corresponding to a component in a composition, a content or amount of the component means the total content or amount of the plurality of different kinds of substances present in the composition unless otherwise specified.

In the present disclosure, particles corresponding to a component may include a plurality of different kinds of particles. In a case in which there are a plurality of different kinds of particles corresponding to a component in a composition, a particle size of the component means a value for a mixture of the plurality of different kinds of particles present in the composition unless otherwise specified.

In the present disclosure, the term "step" encompasses an independent step separated from other step(s) as well as a step that is not clearly separated from other step(s), as long as a purpose of the step can be achieved.

### <<Method of Making Molded Body>>

A method of making a molded body in the present disclosure includes: depressurizing an atmosphere in a container in which a solid resin composition is disposed (also referred to as "depressurizing process"), heating and melting the resin composition after depressurizing the atmosphere in the container (also referred to as "melting process"), and bringing the atmosphere in the container, in which the melted resin composition is disposed, closer to atmospheric pressure (also referred to as "pressure-increasing process"). The method of making a molded body in the present disclosure may include semi-curing or curing the resin composition by further heating the resin composition after the pressure-increasing process, and may include other process(es).

According to the method of making a molded body in the present disclosure, occurrence of voids can be controlled. The reason for the above is not entirely clear; however, it is predicted as follows.

As a solid resin composition for sealing an electronic component, a granular or powdery resin composition is generally used. In the spaces inside the granular or powdery resin composition, continuous air bubbles, i.e., air bubbles having spaces which are connected with each other and through which gas or liquid can pass, is present. When such a solid resin composition is used for case molding, air is caught into the resin composition during the melting of the resin composition by thermal treatment at normal pressure, whereby independent air bubbles, i.e., air bubbles separated from each other and through which gas or liquid cannot pass, remain inside, causing occurrence of voids upon molding the resin composition.

In the method of making a molded body in the present disclosure, since the atmosphere in the container in which a solid resin composition is disposed is depressurized and thereafter the resin composition is heated and melted, the inner spaces of the air bubbles remaining in the melted resin composition are in a depressurized state. Then, upon bringing the atmosphere in the container closer to atmospheric pressure, the air bubbles in the resin composition are crushed due to the external pressure. Consequently, it is presumed that the occurrence of voids can be controlled upon molding of the resin composition.

In sealing an electronic component, it is particularly beneficial to control the occurrence of voids having a diameter of 100 µm or greater, from the viewpoint of assuring reliability of an electronic component. According to the method of making a molded body in the present disclosure, it is possible, for example, to control the occurrence of voids having a diameter of 100 µm or greater, and therefore, the method is particularly useful for sealing in electronic component devices.

In transfer molding in which a resin composition is fully filled in a mold that cover all of the outer surface except at the inlet, and in compression molding in which the filling of the resin composition is performed by pressing the resin composition in a case with an upper lid, filling is performed by mechanically applying pressure to the resin composition in a container when the resin composition is filled in a container. In contrast, it is preferable that the method of making a molded body in the present disclosure does not involve applying pressure mechanically to the resin composition. By case molding not involving mechanical pressurization (hereinafter also referred to as "non-pressurizing case molding"), filling can be conducted in a simple manner.

In the non-pressurizing case molding, filling is conducted uniformly by, for example, the own gravity of the resin composition, without applying pressure to the resin composition in a container, such as a case or mold, in a sealed state. Here, even if a container that covers all surfaces with walls, such as a case having an upper lid, is used, if there is a space at the upper part of the container or the like during the period between disposing the resin composition in the container and filling the resin composition, such a molding method is regarded as corresponding to the non-pressurizing case molding, since the resin composition is not pressurized. Whether or not a molding method corresponds to non-pressurizing case molding is independent of whether pressurization is performed or not after the molding.

The method of making a molded body in the present disclosure can be preferably applied to sealing of an electronic component. In particular, a molded body produced by the method of making a molded body in the present disclosure is preferably used for sealing power modules, which are exposed to severe environment for operation, due to excellent heat resistance and electrical insulation property.

Examples of the electronic component sealed by applying the method of making a molded body in the present disclosure include an element such as an active element and a passive element. Examples of the active element include a semiconductor chip, transistor, diode and a thyristor. Examples of the passive element include a capacitor, a resistor, and a coil. Further, the method may be applied to a modularized electronic component equipped with multiple elements such as the active or passive elements described above.

First, the resin composition used for the method of making a molded body in the present disclosure will be described.

### [Resin Composition]

A solid resin composition is used for the method of making a molded body in the present disclosure. Any resin composition may be used as long as the composition is in a solid form before depressurizing the atmosphere in the container, and for example, a resin composition having a solid form at 25°C can be preferably used. In the present disclosure, a solid resin composition refers to one that has a viscosity of 10⁴ Pa•s or higher before depressurization of the atmosphere in the container, and may include a liquid component as long as the resin composition as a whole is in a solid form.

The solid resin composition may take any shape, such as a form of particles such as powder or granule. In the case of a granular resin composition, the particle sizes are relatively uniform, and therefore, it is less likely that smaller particles go inside the spaces between the particles when the composition is disposed in the container. Further, it is presumed that, since the openings of continuous air bubbles are relatively large, the air inside the air bubbles is efficiently removed during the depressurization, whereby the occurrence of voids can be controlled more effectively.

The resin composition in the present invention includes a thermosetting resin The thermosetting resin composition may further include a curing agent, a filler, a curing accelerator, additive(s) or the like. Components of the thermosetting resin composition will be described below.

### (Thermosetting resin)

The thermosetting resin composition includes a thermosetting resin. The type of thermosetting resin is not particularly limited, and it is preferable that the thermosetting resin includes a thermosetting resin that is curable by an addition reaction. If molecules having a low molecular weight are eliminated during the reaction, such molecules may be vaporized to cause occurrence of voids. However, when a thermosetting resin curable by an addition reaction is used, it is presumed that, since elimination of low-molecular weight molecules does not occur, the occurrence of voids can be controlled more effectively.

The thermosetting resin included in the thermosetting resin composition is not particularly limited. Examples of the thermosetting resin include an epoxy resin, a phenol resin, a bismaleimide resin, a cyanate resin, a polyamide resin, a polyimide resin, and the like. From the viewpoint of the balance of various properties as a sealing material, it is preferable that the thermosetting resin composition includes an epoxy resin.

The type of epoxy resin is not particularly limited, and may be selected in accordance with the desired property of the thermosetting resin composition. Specific Examples of the epoxy resin include: a novolac-type epoxy resin (e.g., a phenol novolac-type epoxy resin or an orthocresol novolac-type epoxy resin) obtained by epoxidizing a novolac resin that is obtained by condensing or co-condensing at least one phenolic compound selected from the group consisting of a phenol compound such as phenol, cresol, xylenol, resorcin, catechol, bisphenol A, and bisphenol F and a naphthol compound such as α-naphthol, β-naphthol, and dihydroxynaphthalene, and an aliphatic aldehyde compound such as formaldehyde, acetaldehyde, or propionaldehyde, under the presence of an acidic catalyst; a triphenylmethane-type epoxy resin obtained by epoxidizing a triphenylmethane-type phenol resin that is obtained by condensing or co-condensing the above-described phenolic compound and an aromatic aldehyde compound such as benzaldehyde or salicylaldehyde under the presence of an acidic catalyst; a copolymerized epoxy resin obtained by epoxidizing a novolac resin that is obtained by co-condensing the above-described phenol compound or naphthol compound with an aldehyde compound under the presence of an acidic catalyst; a diphenylmethane-type epoxy resin that is a diglycidyl ether of bisphenol A, bisphenol F, or the like; a biphenyl-type epoxy resin that is a diglycidyl ether of alkyl-substituted or non-alkyl-substituted biphenol; a stilbene-type epoxy resin which is a diglycidyl ether of a stilbene phenol compound; a sulfur atom-containing epoxy resin that is a diglycidyl ether of bisphenol S or the like; an epoxy resin that is a glycidyl ether of an alcohol such as butanediol, polyethylene glycol, or polypropylene glycol; a glycidyl ester-type epoxy resin that is a glycidyl ester of a polycarboxylic acid compound such as phthalic acid, isophthalic acid, and tetrahydrophthalic acid; a glycidyl amine-type epoxy resin obtained by substituting an active hydrogen, bound to a nitrogen atom of aniline, diaminodiphenylmethane, isocyanuric acid or the like with a glycidyl group; a dicyclopentadiene-type epoxy resin obtained by epoxidizing a co-condensed resin of dicyclopentadiene and a phenol compound; an alicyclic-type epoxy resin obtained by epoxidizing an olefin bond in a molecule, such as vinylcyclohexene diepoxide, 3,4-epoxy cyclohexyl methyl-3,4-epoxy cyclohexane carboxylate, and 2-(3,4-epoxy)cyclohexyl-5,5-spiro(3,4-epoxy)cyclohexane-m-dioxane; a para-xylylene-modified epoxy resin that is a glycidyl ether of a para-xylylene-modified phenol resin; a meta xylylene-modified epoxy resin that is a glycidyl ether of a meta-xylylene-modified phenol resin; a terpene-modified epoxy resin that is a glycidyl ether of a terpene-modified phenol resin; a dicyclopentadiene-modified epoxy resin that is a glycidyl ether of a dicyclopentadiene-modified phenol resin; a cyclopentadiene-modified epoxy resin that is a glycidyl ether of a cyclopentadiene-modified phenol resin; a polycyclic aromatic ring-modified epoxy resin that is a glycidyl ether of a polycyclic aromatic ring-modified phenol resin; a naphthalene-type epoxy resin that is a glycidyl ether of a naphthalene ring-containing phenol resin; a halogenated phenol novolac-type epoxy resin; a hydroquinone-type epoxy resin; a trimethylol propane-type epoxy resin; a linear aliphatic epoxy resin obtained by oxidizing an olefin bond with a peracid such as peracetic acid; and an aralkyl-type epoxy resin obtained by epoxidizing an aralkyl-type phenol resin such as a phenol aralkyl resin or a naphthol aralkyl resin. One kind of epoxy resin may be used singly, or two or more kinds thereof may be used in combination.

The epoxy equivalent weight of the epoxy resin (molecular weight / the number of epoxy group) is not particularly limited. From the viewpoint of properties such as moldability and electric reliability, it is preferable that the epoxy equivalent weight of the epoxy resin is from 100 g/eq to 1000 g/eq, and more preferably from 150 g/eq to 500 g/eq.

An epoxy equivalent weight of an epoxy resin can be measured by a method in accordance with, for example, JIS K 7236:2009.

When the epoxy resin is solid, the softening point or melting point of the epoxy resin is not particularly limited, and is preferably 50 °C or higher from the viewpoint of resistance to thermal decomposition, and is more preferably from 50 °C to 130 °C from the viewpoint of handleability in preparing a thermosetting resin composition.

A melting point of an epoxy resin is a value measured by DSC (differential scanning calorimetry), and a softening point of an epoxy resin is a value measured by a method in accordance with JIS K 7234:1986 (the ring-and-ball method).

### (Curing Agent)

The thermosetting resin composition may include a curing agent. The type of curing agent is not particularly limited, and may be selected depending on the properties desired for the thermosetting resin composition or the like. Examples of a curing agent in the case in which the thermosetting resin is an epoxy resin include a phenol curing agent, an amine curing agent, an acid anhydride curing agent, a polymercaptan curing agent, a polyaminoamide curing agent, an isocyanate curing agent, and a blocked isocyanate curing agent. From the viewpoint of heat resistance, one that has a phenolic hydroxyl group (i.e., a phenol curing agent) is preferable as the curing agent.

Specific examples of the phenol curing agent include: a polyphenol compound such as resorcin, catechol, bisphenol A, bisphenol F, and substituted or unsubstituted biphenol; a novolac-type phenol resin obtained by condensing or co-condensing at least one phenolic compound selected from the group consisting of a phenol compound such as phenol, cresol, xylenol, resorcin, catechol, bisphenol A, bisphenol F, phenylphenol, and aminophenol, and a naphthol compound such as α-naphthol, β-naphthol, and dihydroxynaphthalene, with an alyphatic aldehyde compound such as formaldehyde, acetaldehyde, or propionaldehyde, under the presence of an acidic catalyst; an aralkyl-type phenol resin, such as a phenol aralkyl resin and a naphthol aralkyl resin, synthesized from the above-described phenolic compound and dimethoxyparaxylene, bis(methoxymethyl)biphenyl or the like; a para-xylylene and/or meta-xylylene-modified phenol resin; a melamine-modified phenol resin; terpene-modified phenol resin; a dicyclopentadiene-type phenol resin and a dicyclopentadiene-type naphthol resin synthesized by copolymerization of the above-described phenolic compound and dicyclopentadiene; a cyclopentadiene-modified phenol resin; a polycyclic aromatic ring-modified phenol resin; a biphenyl-type phenol resin; a triphenylmethane-type phenol resin obtained by condensing or co-condensing the above-described phenolic compound and an aromatic aldehyde compound such as benzaldehyde and salicylaldehyde under the presence of an acidic catalyst; and a phenol resin obtained by copolymerizing two or more kinds thereof. One kind of phenol curing agent may be used singly, or two or more kinds thereof may be used in combination.

The functional group equivalent weight of the curing agent (or the hydroxyl group equivalent weight in the case of a phenol curing agent) is not particularly limited, and is preferably from 70 g/eq to 1000 g/eq, and more preferably from 80 g/eq to 500 g/eq, from the viewpoint of the balance of various properties such as moldability and electric reliability.

A functional group equivalent weight of a curing agent (or the hydroxyl group equivalent weight in the case of a phenol curing agent) can be measured by, for example, a method in accordance with JIS K 0070:1992.

When the curing agent is solid, the softening point or melting point of the curing agent is not particularly limited, and is preferably from 40°C or higher from the viewpoint of resistance to thermal decomposition, more preferably from 40°C to 180°C from the viewpoint of moldability or the like, and further preferably from 50°C to 130°C from the viewpoint of handleability upon preparation of the epoxy resin composition.

A melting point or softening point of a curing agent is a value that is measured in the same manner as in the case of the melting point or softening point of the epoxy resin.

The ratio of the numbers of equivalent of the thermosetting resin and the curing agent, i.e., the ratio of the number of functional groups in the curing agent to the number of functional groups in the thermosetting resin (number of functional groups in the curing agent / number of functional groups in the thermosetting resin) is not particularly limited. From the viewpoint of reducing respective unreacted components, the ratio of the numbers of equivalent of the thermosetting resin and the curing agent is preferably from 0.5 to 2.0, and more preferably from 0.6 to 1.3. From the viewpoint of moldability or the like, the ratio is further preferably from 0.8 to 1.2.

### (Filler)

The thermosetting resin composition may include a filler. The type of filler in the case in which the thermosetting resin composition includes a filler is not particularly limited. Specific examples of the filler include an inorganic material such as silica (such as fused silica, crystalline silica or the like), glass, alumina, calcium carbonate, zirconium silicate, calcium silicate, silicon nitride, aluminum nitride, boron nitride, beryllia, zirconia, zircon, forsterite, steatite, spinel, mullite, titania, talc, clay, and mica. An inorganic filler having flame-retardant property may also be used. Examples of the inorganic filler having flame-retardant property include a complex metal hydroxide such as aluminum hydroxide, magnesium hydroxide, and magnesium-zinc complex hydroxide, and zinc borate.

Among the above fillers, silica is preferable from the viewpoint of reducing the coefficient of thermal expansion, and alumina is preferable from the viewpoint of high thermal conductivity. One kind of inorganic filler may be used singly, or two or more kinds thereof may be used in combination. Examples of the form of the inorganic filler include powder, beads that are formed in a spherical shape from powder, and fibers.

The content of the filler is not particularly limited. From the viewpoints of flowability and strength, the content of the filler is preferably from 30% by volume to 90% by volume, more preferably from 35% by volume to 80% by volume, further preferably from 40% by volume to 70% by volume, and still more preferably from 50 % by volume to 70 % by volume, with respect to the whole thermosetting resin composition. When the content of the filler is 30% by volume or higher with respect to the whole thermosetting resin composition, there is a tendency that properties of a cured product, such as coefficient of thermal expansion, thermal conductivity and elastic modulus, are improved. When the content of the filler is 90% by volume or lower with respect to the whole thermosetting resin composition, there is a tendency that increase in the viscosity of the thermosetting resin composition can be controlled, whereby flowability is further improved, and moldability is further improved.

When the filler is in a form of particles, the average particle diameter of the filler is not particularly limited. For example, the volume average particle diameter of the filler is preferably from 0.2 µm to 50 µm, and more preferably from 0.5 µm to 30 µm. When the volume average particle diameter of the filler is 0.2 µm or higher, there is a tendency that increase in viscosity of the thermosetting resin composition can be further preferably controlled. When the volume average particle diameter of the filler is 50 µm or lower, there is a tendency that fillability into small spaces is further improved.

The volume average particle diameter of the filler can be measured as a particle diameter at which the cumulative volume reaches 50% counting from particles having a smaller particle diameter in a volume-based particle size distribution (D50) measured using a laser scattering-diffraction particle size distribution analyzer.

### (Curing Accelerator)

The thermosetting resin composition may include a curing accelerator. The type of curing accelerator is not particularly limited, and may be selected depending on, for example, the type of thermosetting resin or desired properties of the thermosetting resin.

Examples of the curing accelerator include: a cycloamidine compound, such as a diazabycycloalkene such as 1,5-diazabicyclo[4.3.0]non-5-ene (DBN) and 1,8-diazabicyclo[5.4.0]undec-7-ene (DBU), 2-methylimidazole, 2-phenylimidazole, 2-phenyl-4-methylimidazole, and 2-heptadecylimidazole; a derivative of the cycloamidine compound; a phenol novolac salt of the cycloamidine compound or the derivative thereof; a compound that is intramolecularly polarized, which is obtained by adding a compound having a π bond such as maleic anhydride, a quinone compound such as 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2,3-dimethoxy-1,4-benzoquinone, or phenyl-1,4-benzoquinone, and diazophenylmethane, to the above compound; a cycloamidinium compound such as a tetraphenyl borate salt of DBU, a tetraphenyl borate salt of DBN, a tetraphenyl borate salt of 2-ethyl-4-methylimidazole and a tetraphenyl borate salt of N-methylmorpholine; a tertiary amine compound such as pyridine, triethyl amine, triethylene diamine, benzyldimethylamine, triethanolamine, dimethylamino ethanol, and tris(dimethylaminomethyl)phenol; a derivative of the tertiary amine compound; an ammonium salt compound such as tetra-n-butylammonium acetate, tetra-n-butylammonium phosphate, tetraethylammonium acetate, tetra-n-hexylammonium benzoate, and tetrapropylammonium hydroxide; a tertiary phosphine such as triphenylphosphine, diphenyl(p- tolyl)phosphine, a tris(alkylphenyl)phosphine, a tris(alcoxyphenyl)phosphine, a tris(alkyl alcoxyphenyl)phosphine, a tris(dialkylphenyl)phosphine, a tris(trialkylphenyl)phosphine, a tris(tetraalkylphenyl)phosphine, a tris(dialcoxyphenyl)phosphine, a tris(trialcoxyphenyl)phosphine, a tris(tetraalcoxyphenyl)phosphine, a trialkylphosphine, a dialkylarylphosphine, and an alkyldiarylphosphine; a phosphine compound such as a complex of the tertiary phosphine described above and an organic boron compound; a compound that is intramolecularly polarized, which is obtained by adding a compound having a π bond such as maleic anhydride, 1, 4,-benzoquinone, 2, 5-toluquinone, 1,4-naphtoquinone, 2,3-dimethylbenzoquinone, 2,6-dimethylbenzoquinone, 2,3-dimetoxy-5-methyl-1,4-benzoquinone, 2,3-dimethoxy-1,4-benzoquinone, or phenyl-1,4-benzoquinone, to the tertiary phosphine or phosphine compound described above; a compound that is intramolecularly polarized, which is obtained by reacting the tertiary phosphine or phosphine compound described above and a halogenated phenol compound such as 4-bromophenol, 3-bromophenol, 2-bromophenol, 4-chlorophenol, 3-chlorophenol, 2-chlorophenol, 4-iodophenol, 3-iodophenol, 2-iodophenol, 4-bromo-2-methylphenol, 4-bromo-3-methylphenol, 4-bromo-2,6-dimethylphenol, 4-bromo-3,5-dimethylphenol, 4-bromo-2,6-di-t-buthylphenol, 4-chloro-1-naphthol, 1-bromo-2-naphthol, 6-bromo-2-naphthol, or 4-bromo-4'-hydroxybiphenyl, followed by dehydrohalogenation; a tetra-substituted phosphonium such as tetraphenylphosphonium, a tetra-substituted phosphonium having no phenyl group bonded to a boron atom such as tetra-p-tolylborate, and a tetra-substituted borate; and a salt of tetraphenylphosphonium and a phenol compound.

The amount of the curing accelerator is preferably 1 part by mass or lower, more preferably 0.5 parts by mas or lower, and further preferably 0.3 parts by mass or lower, with respect to the 100 parts by mass of the thermosetting resin. When the amount of the curing accelerator is 1 part by mass or lower, sufficient gelation time can be secured and excellent fillability can be obtained. The lower limit of the amount of the curing accelerator is not particularly limited, and the thermosetting resin may not include a curing accelerator.

### [Additives]

The thermosetting resin composition may include, in addition to the above-described components, additive(s) such as a coupling agent, a mold releasing agent, a colorant, a defoaming agent, examples of which are listed below. The thermosetting resin may also include additive(s) known in the art as necessary, besides the additives listed below.

### (Coupling Agent)

The thermosetting resin composition may include a coupling agent for increasing adhesiveness between a resin component (such as a thermosetting resin, curing agent, and the like) and a filler. Examples of the coupling agent include known coupling agents which include: a silane compound such as an epoxysilane, a (meth)acryloxysilane, a mercaptosilane, an aminosilane, an alkylsilane, an ureidosilane, and a vinylsilane; titanium compounds; aluminum chelate compounds; and aluminum/zirconium compounds. In particular, a silane compound is preferable from the viewpoint of handleability. One kind of coupling agent may be used singly, or two or more kinds thereof may be used in combination.

When the thermosetting resin composition includes a coupling agent, the amount of the coupling agent is preferably from 0.05 parts by mass to 5 parts by mass, and more preferably from 0.1 parts by mass to 2.5 parts by mass, with respect to 100 parts by mass of the filler.

### (Mold Releasing Agent)

The thermosetting resin composition may include a mold releasing agent. The type of mold releasing agent is not particularly limited, and a conventionally known mold releasing agent may be used. Specific examples include: carnauba wax; a higher fatty acid such as montanic acid and stearic acid; a higher fatty acid metal salt; an ester wax such as montanic acid ester; and a polyolefin-based wax such as oxidized polyethylene and non-oxidized polyethylene. One kind of mold release agent may be used singly, or two or more kinds thereof may be used in combination.

When the thermosetting resin composition includes a mold releasing agent, the amount of the mold releasing agent is preferably from 0.01 parts by mass to 10 parts by mass, and more preferably from 0.1 parts by mass to 5 parts by mass, with respect to 100 parts by mass of the total amount of the thermosetting resin and the curing agent.

### (Colorant)

The thermosetting resin composition may further include a colorant. Examples of the colorant include known colorants such as carbon black, organic dyes, organic pigments, titanium oxide, red lead, and colcothar. The amount of the colorant may be selected as necessary, depending on the purpose or the like. One kind of colorant may be used singly, or two or more kinds thereof may be used in combination.

When the thermosetting resin composition includes a colorant, the amount of the colorant is preferably from 0.01 parts by mass to 10 parts by mass, and more preferably from 0.1 parts by mass to 5 parts by mass, with respect to 100 parts by mass of the total amount of the thermosetting resin and the curing agent.

### (Defoaming Agent)

The thermosetting resin composition may include a defoaming agent. By using a defoaming agent, generation of bubbles can be controlled or reduced, the bubbles being generated during the depressurization step, melting step, temperature-increasing step and any other optional step(s), by volatilization of volatile components or the like such as moisture absorbed by the thermosetting resin composition, small-molecular-weight impurities included in respective raw materials of the composition, monomeric components, and low-molecular-weight groups eliminated through reactions. Examples of the defoaming agent include known defoaming agents such as polyether, polyester, a higher alcohol, a higher alcohol derivative, a fatty acid derivative, soap scum, silicone oil, polysiloxane, wax, and paraffinum liquidum. One kind of defoaming agent may be used singly, or two or more thereof may be used in combination.

When the thermosetting resin composition includes a defoaming agent, the content of the defoaming agent may be selected as necessary, and it is preferable that the content of an active component of the defoaming agent is from 0.01% by mass to 10% by mass, and more preferably from 0.01% by mass to 5% by mass, with respect to the thermosetting resin composition.

### (Properties, Preparation and the like of the Thermosetting Resin Composition)

In the thermosetting rein composition, gelation time at 110°C is preferably 10 minutes or more, more preferably 30 minutes or more, and further preferably 60 minutes or more. When the gelation time at 110°C is 10 minutes or more, there is a tendency that sufficient time before gelation can be secured, whereby, even in the case in which a solid resin composition is applied to case molding, excellent fillability can be obtained. Here, since preferable gelation time at 110°C fluctuates depending on the production process, it is preferable that the gelation time at 110°C is selected as appropriate. Therefore, preferable gelation time at 110°C is not limited to the above range.

Gelation time at 110°C is measured in accordance with JIS K 6300-2:2001. Specifically, torque, received via a thermosetting resin composition when torsional vibration is applied at a constant pressure at 110°C, is measured, and the gelation time is determined as the time at which the torque clearly starts to rise.

In the thermosetting resin composition, gelation time at 175°C is preferably two hours or less, more preferably an hour or less, and further preferably 25 minutes or less. When the gelation time at 175°C is two hours or less, there is a tendency that the curing time can be shortened thereby saving the process time for making an electronic component device.

Gelation time at 175°C is measured in accordance with JIS K 6300-2:2001, in the same manner as in the measurement of gelation time at 110°C, except that the temperature is changed to 175°C.

The viscosity of the thermosetting resin composition at 110°C is preferably 500 Pa• s or less, and more preferably 100 Pa•s or less. When the viscosity at 110°C is 500 Pa•s or less, excellent moldability tends to be obtained.

A viscosity of a thermosetting resin composition at 110°C is measured using a rheometer (cone diameter: 25 mm, frequency: 1 Hz). Examples of the rheometer include "AR2000 (product name, TA Instruments).

In the thermosetting resin composition, it is preferable that the ratio of the glass transition temperatures (Tg) of a cured product before and after treatment at 215°C for 1000 hours (Tg after 1000 hours / initial Tg) is 0.9 or higher. When the ratio "Tg after 1000 hours / initial Tg" is 0.9 or higher, excellent retention under high temperature can be obtained, and therefore, the composition can be more preferably applied to the sealing of power modules that generates large amount of heat. A glass transition temperature (Tg) can be measured by the TMA (thermomechanical analysis) method.

The average coefficient of thermal expansion of a cured product of the thermosetting resin composition at 30°C to 250°C is preferably 50 ppm/K or lower, and more preferably 40 ppm/K or lower. When the average coefficient of thermal expansion at 30°C to 250°C is 40 ppm/K or lower, difference in the coefficients of thermal expansion between a semiconductor chip and an electronic component becomes smaller, whereby occurrence of warpage caused by heat tends to be efficiently controlled.

An average coefficient of thermal expansion can be measured as follows. An average coefficient of thermal expansion can be measured by preparing a cured product having a size of 3 mm x 3 mm x 10 mm, and performing the measurement under the condition of 0.2 N load, 30°C to 260°C, and the temperature increase rate of 5 °C/minute.

The elastic modulus of a cured product of the thermosetting resin composition at 25 °C is preferably from 5 GPa to 25 GPa, and more preferably from 10 GPa to 20 GPa. When the elastic modulus at 25°C is 5 GPa or higher, there is a tendency that stress arising due to a difference in coefficient of thermal expansion between the cured product and other members of a power module can be efficiently controlled. When the elastic modulus at 25°C is 25 GPa or lower, there is a tendency that the generated stress caused by the cured product of the thermosetting resin composition itself can be effectively controlled.

An elastic modulus at 25°C can be measured by the following method. An elastic modulus at 25°C is measured by preparing a cured product having a size of 10 mm x 50 mm x 3 mm, and, using a thermomechanical analyzer (such as "RSA III", TA Instruments), increasing the temperature between 25°C to 300°C at a rate of 10 °C/minute to obtain an elastic modulus (GPa) at 25°C.

Preparation of the thermosetting resin composition may be performed by any conventionally known method. A kneader, a planetary mixer, a three roll mill, a twin-screw extruder or the like is preferably used.

Next, respective processes included in the method of making a molded body in the present disclosure will be described.

### < 1. Depressurizing an atmosphere in a container in which a solid resin composition is disposed (depressurization process) >

In this process, the atmosphere in a container in which a solid resin composition is disposed is depressurized. The depressurization may be conducted by, for example, placing the container, in which the solid resin composition is disposed, in a vacuum dryer or the like, and venting air therefrom.

The container in which the resin composition is disposed may be any container such as a case or a mold. The container may have an upper lid, and may be free of an upper lid. From the viewpoint of adjusting the pressure in the container efficiently, it is preferable that the container has an upper lid having an aeration property, or has no upper lid.

The container may be a container in which an electronic component to be sealed is housed in advance, and may be a container in which an electronic component to be sealed is not housed in advance. When a container in which the electronic component to be sealed is housed in advance is used, sealing of the electronic component can be performed directly by curing the resin composition using the method of making a molded body in the present disclosure. Further, when a container in which the electronic component to be sealed is not housed in advance is used, material that can be remelted and used for sealing an electronic component can be provided by making a semi-cured molded body using the method of making a molded body in the present disclosure.

From the viewpoint of controlling the occurrence of voids, the closer the degree of depressurization is to the absolute zero vacuum, the more preferable. It is preferable that the depressurization is performed to 667 Pa or lower, more preferably to 134 Pa or lower, and further preferably to 50 Pa or lower.

The speed of the depressurization is not particularly limited, and may be determined according to the performance of the device or the like.

The temperature of the atmosphere during the depressurization process is not particularly limited, and may be determined according to the type of resin composition. Since it is preferable that the spaces in the resin composition is maintained in a form of continuous air bubbles throughout the depressurization process, the temperature of the atmosphere is lower than the softening point or melting point of the resin contained in the resin composition. From the viewpoint of simplicity, the depressurization is preferably conducted at ordinary temperature.

### < 2. Heating and melting the resin composition after depressurizing the atmosphere in the container (melting process) >

In this process, the resin composition that has undergone the depressurizing process is heated and melted. The temperature for melting the resin composition can be determined in accordance with the softening point or melting point, or components of the resin composition or the like. For example, when a thermosetting resin composition including an epoxy resin is used, the resin composition may be heated to 90°C to 175°C to be melted.

The melting process is preferably performed while the depressurized atmosphere is being maintained. In the melting process, the degree of depressurization may be fluctuated; however, by performing the melting process in a depressurized state as compared to atmospheric pressure, an effect obtained by the pressure-increasing process described later can be preferably obtained.

One or both of the following features "temperature increase rate" and "time between initiation of heating and bringing the atmosphere in the container closer to atmospheric pressure" is satisfied in the method of the invention.

From the viewpoints of saving the process time and controlling the increase in viscosity of the resin composition, the temperature increase rate during the temperature increase of the resin composition by heating is preferably from 0.5 °C/minute or higher, more preferably 1.0 °C/minute or higher, further preferably 2.5 °C/minute or higher, and still more preferably 5.0 °C/minute or higher. The upper limit of the temperature increase rate is not particularly limited, and may be adjusted in accordance with the properties of the devices used, or the like. The upper limit of the temperature increase rate may be, for example, 20 °C/minute or lower.

The temperature increase rate may be stable or may be fluctuated during the temperature-increasing process. Further, the resin composition may be melted by increasing the temperature to a predetermined temperature and maintaining the temperature stably. In a case in which it is difficult to measure the temperature of the resin composition directly, the temperature of the container in which the resin composition is disposed may be measured, which may be regarded as the temperature of the resin composition.

From the viewpoints of saving the process time and controlling the increase in viscosity of the resin composition, the time between the initiation of the heating in the melting process and the initiation of the pressure-increasing process described later is preferably 240 minutes or shorter, more preferably 120 minutes or shorter, and further preferably 60 minutes or shorter.

The manner of heating is not particularly limited. Heating may be performed by any of conduction, radiation, or convection, or any combination thereof. From the viewpoint of heating efficiency, it is preferable that the heating is performed by conduction or radiation, and it is more preferable that the heating is performed by conduction.

Examples of the heating by conduction include a method of equipping a shelf plate, on which the container with the resin composition therein is to be placed, with a heater to conduct the heating, and a method in which the container with the resin composition therein is heated directly or indirectly using a heating medium such as oil or the like. Examples of the heating by radiation include irradiating the container with the resin composition therein with a halogen heater. Examples of the heating by convection include a method of raising the temperature of the atmosphere inside a vacuum dryer in which the container with the resin composition therein is placed. It is preferable that these methods are combined as appropriate.

The heating is performed from the vertical bottom side of the container in which the resin composition is disposed, and preferably performed by conduction from the vertical bottom side of the container in which the resin composition is disposed. It is presumed that this enables to control the occurrence of voids more efficiently. When a resin composition is heated from the vertical bottom side, the vertical bottom part of the resin composition is melted first to start flowing. It is presumed that this renders the vertical bottom part of the resin composition to be pressed by its own gravity, and deaeration proceeds sequentially from the vertical bottom part. Further, it is presumed that the above procedure can reduce the possibility of deaeration becoming less likely to proceed due to the viscosity of the upper part of the resin composition being increased first. Other method(s) of heating may be combined with the method of heating from the vertical bottom side.

### <3. Bringing the atmosphere in the container, in which the melted resin composition is disposed, closer to atmospheric pressure (pressure-increasing process) >

In this process, the atmosphere in the container, in which the resin composition that has undergone the melting process is disposed, is brought closer to atmospheric pressure. Here, the term "pressure-increasing" refers to bringing the atmosphere in a depressurized state closer to atmospheric pressure, and is different from "pressurization", that is, applying mechanical pressure.

In the pressure-increasing process, the resin composition is in a melted state, and has flowability. In the present disclosure, a "melted state" refers to a state at which the viscosity is 500 Pa•s or lower. It is presumed that, by the above process, independent air bubbles remaining inside the resin composition can be pressurized by atmospheric pressure, and that deaeration occurs due to the flow of the resin composition.

A viscosity of a resin composition can be measured using a rheometer (cone diameter: 25 mm, wavelength: 1 Hz). Examples of the rheometer that may be used include, for example, "AR2000" (product name, TA Instruments).

The pressure increase rate is not particularly limited, and it is preferable that the pressure increase is conducted rapidly from the viewpoint of saving the process time. The pressure-increasing process can be conducted easily by, for example, opening a valve of a vacuum dryer so that the atmosphere inside the vacuum dryer is open to atmospheric pressure.

### < 4. Semi-curing or curing the resin composition by further heating the resin composition after bringing the atmosphere in the container closer to atmospheric pressure >

The method of making a molded body in the present application may further include semi-curing or curing the resin composition by further heating the resin composition after the pressure-increasing process.

In a case in which, for example, the depressurization process, melting process, and pressure-increasing process are performed using a container in which an electronic component to be sealed is housed in advance, an electronic component device may be made by sealing the electronic component by further heating and curing the resin composition. The curing condition is not particularly limited. For example, when a resin composition including an epoxy resin is used, the curing may be conducted at a temperature of 170°C to 250°C for 1 to 24 hours. When the depressurization process, the melting process and the temperature-increasing process are performed in a vacuum dryer, the heating for the curing may be performed in the same vacuum dryer, and may be performed using, such as an oven, after retrieving the resin composition from the vacuum dryer.

Further, in a case in which, for example, the depressurization process, melting process, and pressure-increasing process are performed using a container in which an electronic component to be sealed is not housed in advance, further heating may be performed to semi-cure the resin composition, thereby making a material usable for sealing an electronic component by remelting the resin composition. Here, "semi-cured" refers to a state in which the composition is solid or has a viscosity of 10⁴ Pa•s or higher at 25°C, whereas the viscosity at 100°C, for example, is lowered to 10³ Pa•s or lower, the state being generally called "B stage". The definition of the "B stage" is provided in JIS K 6900:1994. The condition for the semi-curing is not particularly limited. When, for example, a thermosetting resin composition including an epoxy resin is used, the semi-curing may be performed at a temperature of within 90°C to 175°C for the period of within 4 hours. When the depressurization process, melting process and pressure-increasing process are conducted in a vacuum dryer, the heating for the semi-curing may be performed in the same vacuum dryer, and may be performed in an oven or the like after retrieving the composition. Further, the semi-curing may be performed with the air in the vacuum dryer or the tank of the oven replaced with inactive gas such as nitrogen or the like, as necessary.

A semi-cured resin composition may be obtained without further performing a heating process after the depressurization process, melting process and pressure-increasing process.

### Examples

Hereinafter, the embodiments described above will be further specifically illustrated in reference to the Examples. However, the scope of the embodiments is not limited to these Examples.

### (Preparation of Thermosetting Resin Composition)

The components listed in Table 1 were mixed in the amounts shown in Table 1 (parts by mass), and the mixture was kneaded using a twin-screw extruder, the internal temperature being adjusted to 70°C to 100°C. After cooling, pulverization was performed to prepare a thermosetting resin composition. The value in parenthesis in the "Inorganic Filler" column refers to a volume-based ratio (% by volume) of the filler in the thermosetting resin composition. Details of the respective components are provided below.
- Epoxy Resin: a multi-functional epoxy resin having an epoxy equivalent weight of 163 g/eq to 175 g/eq and a softening point of 57°C to 63°C
- Curing Agent: A phenol novolac resin having a hydroxyl group equivalent weight of 106 g/eq and a softening point of 68°C to 74°C
- Curing Accelerator: 2-phenylimidazole
- Coupling Agent: N-phenyl-(3-aminopropyl)trimethoxysilane
   - Mold Releasing Agent: montanic acid ester
   - Colorant: Carbon Black
   - Defoaming Agent: polysiloxane
   - Inorganic Filler: fused silica particles having a D50 (value in catalog) of 19.9 µm

### (Measurement of Viscosity)

The above-prepared thermosetting resin composition was heated to 110°C, and the viscosity was measured using a rheometer (cone diameter: 25 mm, wavelength: 1 Hz).

### (Measurement of Gelation Time)

Torque, received via the thermosetting resin composition when torsional vibration was applied at a constant pressure at a certain temperature (110°C or 175°C), was measured, and the gelation time was determined as the time at which the torque clearly started to rise.

### Results are shown in Table 1.

**[Table 1]**

| Thermosetting Resin Composition | | |
|---|---|---|
| Amount (parts by mass) | Epoxy Resin | 100 |
| | Curing Agent | 62.8 |
| | Curing Accelerator | 0.03 |
| | Coupling Agent | 1.5 |
| | Mold Releasing Agent | 1 |
| | Colorant | 1 |
| | Defoaming Agent | 2.1 |
| | Inorganic Filler (value in parenthesis: % by volume) | 522 (62) |
| State at 25°C (room temperature) | | solid |
| Viscosity at 100°C | | 30 Pa•s |
| Gelation Time | 110°C | > 240 minutes |
| | 175°C | 19 minutes |

### (Molding of Resin Composition)

### <Example 1>

60 g of the thermosetting resin composition was disposed in an aluminum cup having a diameter of 60 mm and a depth of 40 mm, and then was placed in a vacuum dryer "DN-30S" (product name; manufactured by Sato Vac. Inc.) set at 23°C. Then the pressure in the vacuum dryer was reduced to 50 Pa. Thereafter, the temperature was raised to 120°C at a temperature increase rate of 0.7 °C/minute, and maintained at 120°C for 30 minutes. Thereafter, the inside of the vacuum dryer was promptly returned to atmospheric pressure and was cooled. After the cooling, heating was performed at 175°C for four hours in an oven that had been prepared separately, to obtain a cured product.

### <Example 2>

A cured product was obtained in the same manner as in Example 1, except that the pressure in the vacuum dryer was reduced to 667 Pa.

### <Example 3>

A cured product was obtained in the same manner as in Example 1, except that the temperature increase rate was 1.4 °C/minute.

### <Comparative Example 1>

60 g of the thermosetting resin composition was disposed in an aluminum cup having a diameter of 60 mm and a depth of 40 mm, and then was placed in a vacuum dryer "DN-30S" (product name; manufactured by Sato Vac. Inc.) set at 23°C. Then, the temperature was raised to 120°C at a temperature increase rate of 0.7 °C/minute. Thereafter, the pressure in the vacuum dryer was reduced to 50 Pa and maintained for 30 minutes. Thereafter, the inside of the vacuum dryer was promptly returned to atmospheric pressure and was cooled. After the cooling, heating was performed at 175°C for four hours in an oven that had been prepared separately, to obtain a cured product.

### <Comparative Example 2>

A cured product was obtained in the same manner as in Comparative Example 1, except that pressure in the vacuum dryer was not reduced and maintained at atmospheric pressure.

### (Evaluation of Voids)

The cured products obtained in Examples 1 to 3 and Comparative Examples 1 and 2 were cut using a precision cutter "MICRO CUTTER MC-201" (product name, manufactured by Maruto Instrument Co., Ltd.), and their cross-section surfaces were observed using a microscope "BX-51" (product name, manufactured by Olympus Corporation).

As a result, no voids having a diameter of 100 µm or more was found in Examples 1 to 3.

On the other hand, in Comparative Examples 1 and 2, a number of voids having a diameter of 100 µm or more were observed, and therefore, the compositions were not suitable for sealing electronic components.

## Claims

1. A method of making a molded body, the method comprising:
depressurizing an atmosphere in a container in which a solid resin composition is disposed, the temperature of the atmosphere being lower than the softening point or melting point of the resin contained in the resin composition,
heating and melting the resin composition after depressurizing the atmosphere in the container, the heating being performed from the vertical bottom side of the container such that the vertical bottom part of the resin composition starts to melt and flow first, and
bringing the atmosphere in the container, in which the melted resin composition is disposed, closer to atmospheric pressure, the melted resin composition having a viscosity of 500 Pa·s or lower,
wherein the resin composition comprises a thermosetting resin, and
wherein at least one of the following features (i) and (ii) is satisfied:
(i) the time between initiation of heating and bringing the atmosphere in the container closer to atmospheric pressure is 240 minutes or shorter;
(ii) in the heating and melting of the resin composition, a temperature increase rate of the resin composition is 0.5 °C/minute or higher.

2. The method of making a molded body according to claim 1, wherein the method does not comprise applying pressure mechanically to the resin composition.

3. The method of making a molded body according to claim 1 or 2, wherein depressurizing the atmosphere in the container involves depressurization to 667 Pa or lower.

4. The method of making a molded body according to any one of claims 1 to 3, wherein the thermosetting resin comprises a thermosetting resin that is curable by an addition reaction.

5. The method of making a molded body according to any one of claims 1 to 4, wherein the thermosetting resin comprises an epoxy resin.

6. The method of making a molded body according to any one of claims 1 to 5, wherein, in the heating and melting of the resin composition, the heating is performed by conduction.

7. The method of making a molded body according to any one of claims 1 to 6, further comprising, after bringing the atmosphere in the container closer to atmospheric pressure, semi-curing or curing the resin composition by further heating the resin composition.

8. A method of making an electronic component device, the method comprising sealing an electronic component using the method of making a molded body according to claim 7.

## Patentansprüche

1. Verfahren zur Herstellung eines Formkörpers, wobei das Verfahren Folgendes umfasst:
Druckentlasten einer Atmosphäre in einem Behälter, in dem sich eine feste Harzzusammensetzung befindet, wobei die Temperatur der Atmosphäre niedriger als der Erweichungspunkt oder der Schmelzpunkt des in der Harzzusammensetzung enthaltenen Harzes ist,
Erhitzen und Schmelzen der Harzzusammensetzung nach dem Druckentlasten der Atmosphäre im Behälter, wobei das Erhitzen von der vertikalen Unterseite des Behälters aus durchgeführt wird, so dass der vertikale untere Teil der Harzzusammensetzung zuerst zu schmelzen und fließen beginnt, und
Annähern der Atmosphäre in dem Behälter, in dem sich die geschmolzene Harzzusammensetzung befindet, an den atmosphärischen Druck, wobei die geschmolzene Harzzusammensetzung eine Viskosität von 500 Pa·s oder weniger aufweist,
wobei die Harzzusammensetzung ein wärmehärtbares Harz umfasst, und
wobei mindestens eines der folgenden Merkmale (i) und (ii) erfüllt ist:
(i) die Zeit zwischen Beginn der Erwärmung und dem Annähern der Atmosphäre im Behälter an den atmosphärischen Druck beträgt 240 Minuten oder weniger;
(ii) beim Erhitzen und Schmelzen der Harzzusammensetzung beträgt die Temperaturanstiegsrate der Harzzusammensetzung 0,5 °C/Minute oder mehr.

2. Verfahren zur Herstellung eines Formkörpers nach Anspruch 1, wobei das Verfahren kein mechanisches Aufbringen von Druck auf die Harzzusammensetzung umfasst.

3. Verfahren zur Herstellung eines Formkörpers nach Anspruch 1 oder 2, wobei das Druckentlasten der Atmosphäre in dem Behälter ein Druckentlasten auf 667 Pa oder weniger beinhaltet.

4. Verfahren zur Herstellung eines Formkörpers nach einem der Ansprüche 1 bis 3, wobei das wärmehärtbare Harz ein wärmehärtbares Harz umfasst, das durch eine Additionsreaktion härtbar ist.

5. Verfahren zur Herstellung eines Formkörpers nach einem der Ansprüche 1 bis 4, wobei das wärmehärtbare Harz ein Epoxidharz umfasst.

6. Verfahren zur Herstellung eines Formkörpers nach einem der Ansprüche 1 bis 5, wobei beim Erhitzen und Schmelzen der Harzzusammensetzung das Erhitzen durch Wärmeleitung durchgeführt wird.

7. Verfahren zur Herstellung eines Formkörpers nach einem der Ansprüche 1 bis 6, weiter umfassend, nach dem Annähern der Atmosphäre im Behälter an den atmosphärischen Druck, Halbaushärten oder Aushärten der Harzzusammensetzung durch weiteres Erhitzen der Harzzusammensetzung.

8. Verfahren zur Herstellung eines elektronischen Bauelements, wobei das Verfahren das Versiegeln einer elektronischen Komponente unter Verwendung des Verfahrens zur Herstellung eines Formkörpers nach Anspruch 7 umfasst.

## Revendications

1. Procédé de fabrication d'un corps moulé, le procédé comprenant :
la dépressurisation d'une atmosphère dans un récipient dans lequel une composition de résine solide est disposée, la température de l'atmosphère étant inférieure au point de ramollissement ou au point de fusion de la résine contenue dans la composition de résine,
le chauffage et la fonte de la composition de résine après avoir dépressurisé l'atmosphère dans le récipient, le chauffage étant effectué à partir du fond vertical du récipient de telle sorte que la partie inférieure verticale de la composition de résine commence à fondre et à s'écouler en premier, et
le rapprochement de l'atmosphère dans le récipient, dans lequel la composition de résine fondue est disposée, à la pression atmosphérique, la composition de résine fondue présentant une viscosité de 500 Pa·s ou moins,
dans lequel la composition de résine comprend une résine thermodurcissable, et
dans lequel au moins l'une des caractéristiques suivantes (i) et (ii) est satisfaite :
(i) le temps entre le début du chauffage et le rapprochement de l'atmosphère dans le récipient à la pression atmosphérique est de 240 minutes ou moins ;
(ii) lors du chauffage et de la fusion de la composition de résine, le taux d'augmentation de la température de la composition de résine est de 0,5 °C/minute ou plus.

2. Procédé de fabrication d'un corps moulé selon la revendication 1, dans lequel le procédé ne comprend pas l'application d'une pression mécanique à la composition de résine.

3. Procédé de fabrication d'un corps moulé selon la revendication 1 ou la revendication 2, dans lequel la dépressurisation de l'atmosphère dans le récipient implique une dépressurisation à 667 Pa ou moins.

4. Procédé de fabrication d'un corps moulé selon l'une quelconque des revendications 1 à 3, dans lequel la résine thermodurcissable comprend une résine thermodurcissable qui est durcissable par une réaction d'addition.

5. Procédé de fabrication d'un corps moulé selon l'une quelconque des revendications 1 à 4, dans lequel la résine thermodurcissable comprend une résine époxy.

6. Procédé de fabrication d'un corps moulé selon l'une quelconque des revendications 1 à 5, dans lequel, lors du chauffage et de la fusion de la composition de résine, le chauffage est effectué par conduction.

7. Procédé de fabrication d'un corps moulé selon l'une quelconque des revendications 1 à 6, comprenant en outre, après avoir rapproché l'atmosphère dans le récipient à la pression atmosphérique, le semi-durcissement ou le durcissement de la composition de résine par chauffage supplémentaire de la composition de résine.

8. Procédé de fabrication d'un dispositif à composant électronique, le procédé comprenant le scellement d'un composant électronique en utilisant le procédé de fabrication d'un corps moulé selon la revendication 7.
